(19) Europäisches Patentamt
European Patent Office
Office européen des brevets

(11) **EP 4 397 990 A1**

(12) **EUROPEAN PATENT APPLICATION**
published in accordance with Art. 153(4) EPC

(43) Date of publication:
**10.07.2024 Bulletin 2024/28**

(21) Application number: **22864593.3**

(22) Date of filing: **30.08.2022**

(51) International Patent Classification (IPC):
*G01S 7/03* (2006.01)     *H01Q 1/52* (2006.01)
*H01Q 17/00* (2006.01)     *H05K 9/00* (2006.01)

(52) Cooperative Patent Classification (CPC):
**G01S 7/03; H01Q 1/52; H01Q 17/00; H05K 9/00**

(86) International application number:
**PCT/JP2022/032686**

(87) International publication number:
**WO 2023/033011 (09.03.2023 Gazette 2023/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **03.09.2021 JP 2021144069**

(71) Applicant: **NITTO DENKO CORPORATION
Ibaraki-shi
Osaka 567-8680 (JP)**

(72) Inventors:
• **MATSUZAKI Yuya**
**Ibaraki-shi, Osaka 567-8680 (JP)**
• **FUKE Kazuhiro**
**Ibaraki-shi, Osaka 567-8680 (JP)**
• **UI Takehiro**
**Ibaraki-shi, Osaka 567-8680 (JP)**
• **AKIYAMA Kyohei**
**Ibaraki-shi, Osaka 567-8680 (JP)**

(74) Representative: **Grünecker Patent- und
Rechtsanwälte
PartG mbB
Leopoldstraße 4
80802 München (DE)**

(54) **ELECTROMAGNETIC WAVE SHIELD**

(57)     An electromagnetic shield 10a includes a plate-shaped solid portion 15 having a first surface 13 configured to allow an electromagnetic wave to be incident on the first surface 13. The solid portion 15 includes solid dielectrics having different relative permittivities. The solid dielectrics are disposed in turn in contact with each other in a particular direction along the first surface 13.

FIG.1

EP 4 397 990 A1

**Description**

TECHNICAL FIELD

The present invention relates to an electromagnetic shield.

BACKGROUND ART

Covers for protecting radar devices have been known.

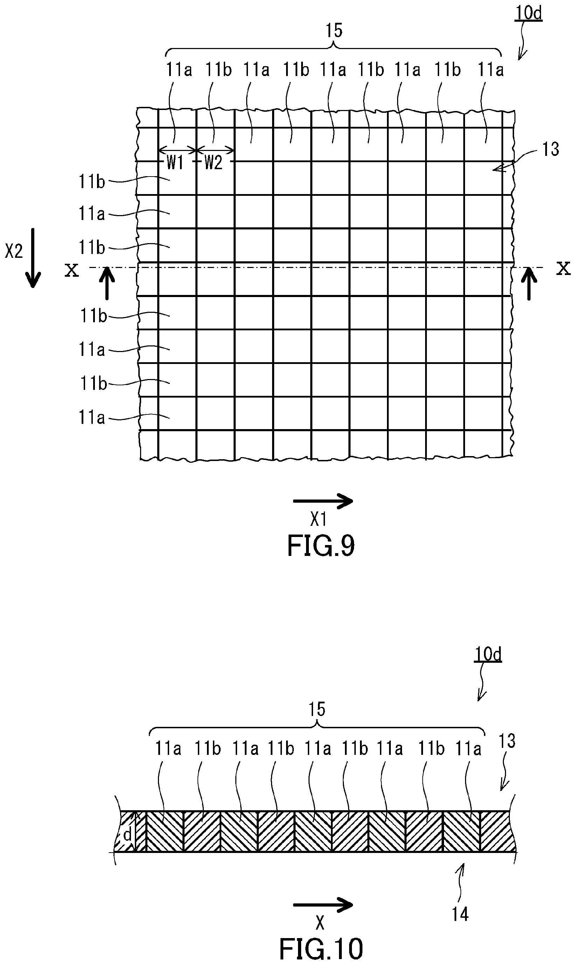

Patent Literature 1 describes a side shield for radar transceivers. A non-uniform delay structure is disposed over the entire side shield. In this side shield, the non-uniform delay structure has, for example, a non-uniform dielectric constant along a normal vector V (refer to FIG. 9). The delay structure includes an embedded portion and a carrier structure. The embedded portion has a dielectric constant different from that of the carrier structure.

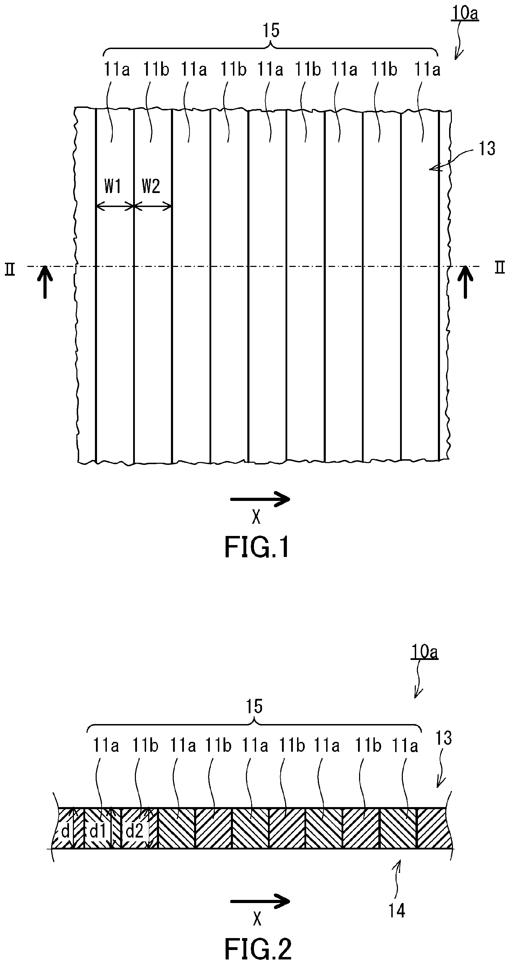

Patent Literature 2 describes an electromagnetic wave absorber in which scattering bodies made of a second dielectric material and each having a particular shape are cyclically arranged in a matrix made of a first dielectric material. In an example of the arrangement in the electromagnetic wave absorber, flat plates of the matrix and flat plates of the scattering bodies are alternately stacked (refer to FIG. 1(a)). In the electromagnetic wave absorber, a plane part of the matrix serves as an electromagnetic incident surface.

CITATION LIST

Patent Literature

    Patent Literature 1: WO 2021/058450 A1
    Patent Literature 2: JP 2004-153135 A1

SUMMARY OF INVENTION

Technical Problem

Electromagnetic shielding is conceivable for prevention of reception of unnecessary radio waves. For example, when an electromagnetic shielding member has given protrusions and depressions formed on its surface configured to allow an electromagnetic wave to be incident thereon, the electromagnetic shielding member can exhibit given electromagnetic shielding properties owing to a difference between the relative permittivity of the material of the member and the relative permittivity of air and the protrusions and depressions. However, if the protrusions and depressions formed on the member's surface configured to allow an electromagnetic wave to be incident thereon are large in dimensions, foreign matters such as dirt and water are likely to accumulate thereon, decreasing the electromagnetic shielding properties of the member.

It is understood that in the side shield of Patent Literature 1, the embedded portion is embedded in the carrier structure and a surface of the side shield is made of the material of the carrier structure, the surface being configured to allow a radar signal to be incident thereon. Therefore, the relative permittivity is thought to be constant across the surface.

In the electromagnetic wave absorber of Patent Literature 2, the plane part of the matrix serves as an electromagnetic incident surface. It is therefore thought that the relative permittivity is constant across the incident surface of this electromagnetic wave absorber. An electromagnetic wave incident on this electromagnetic wave absorber attenuates as it enters the matrix and is scattered by one scattering body after another.

Hence, the present invention provides an electromagnetic shield that has different relative permittivities at positions on a surface configured to allow an electromagnetic wave to be incident thereon and on which foreign matters such as dirt and water are less likely to accumulate.

Solution to Problem

The present invention provides an electromagnetic shield including:

    a plate-shaped solid portion having a first surface configured to allow an electromagnetic wave to be incident on the first surface, wherein

the solid portion includes solid dielectrics having different relative permittivities, and
the solid dielectrics are disposed in turn in contact with each other in a particular direction along the first surface.

Advantageous Effects of Invention

The above electromagnetic shield has different relative permittivities at positions on the surface configured to allow an electromagnetic wave to be incident thereon. Moreover, foreign matters are less likely to accumulate on the above electromagnetic shield.

BRIEF DESCRIPTION OF DRAWINGS

FIG. 1 is a plan view showing an example of an electromagnetic shield according to the present invention.
FIG. 2 is a cross-sectional view showing the electromagnetic shield along a II-II line shown in FIG. 1.
FIG. 3 schematically shows a transmission loss measurement method.
FIG. 4 is a plan view showing an example of a radar cover according to the present invention.
FIG. 5 is a cross-sectional view showing the radar cover along a V-V line shown in FIG. 4.
FIG. 6 is a plan view showing another example of the radar cover.
FIG. 7 is a cross-sectional view showing another example of the electromagnetic shield.
FIG. 8 is a cross-sectional view showing yet another example of the electromagnetic shield.
FIG. 9 is a plan view showing yet another example of the electromagnetic shield.
FIG. 10 is a cross-sectional view showing the electromagnetic shield along an X-X line shown in FIG. 9.
FIG. 11 schematically shows a return loss measurement method.

DESCRIPTION OF EMBODIMENTS

Embodiments of the present invention will be described with reference to the drawings. The present invention is not limited to the following embodiments.

As shown in FIGS. 1 and 2, an electromagnetic shield 10a includes a plate-shaped solid portion 15 having a first surface 13. The first surface 13 is a surface configured to allow an electromagnetic wave to be incident on the first surface 13. The solid portion 15 includes solid dielectrics having different relative permittivities. The solid dielectrics are disposed in turn in contact with each other in a particular direction (X axis direction) along the first surface 13. In other words, a pair of solid dielectrics adjacent to each other in the particular direction along the first surface 13 have different relative permittivities. The different types of solid dielectrics may be disposed in a regular order or in an irregular order in the particular direction. Consequently, the electromagnetic shield 10a can exhibit a function of attenuating the energy of an electromagnetic wave. The principle on which an electromagnetic shield attenuates the energy of an electromagnetic wave is not limited to a particular principle. The principle can be, for example, one using a phenomenon, such as reflection, transmission, absorption, diffraction, or interference, accompanying an interaction between an electromagnetic wave and an electromagnetic shield and a phenomenon, such as scattering or diffusion of the electromagnetic wave, caused by the above phenomenon. The energy of a given electromagnetic wave incident on the first surface 13 of the electromagnetic shield 10a attenuates. In the electromagnetic shield 10a, the height of the first surface 13 is unlikely to vary greatly. This is because the solid dielectrics are disposed in turn along the first surface 13. Therefore, foreign matters such as dirt and water are less likely to accumulate on the electromagnetic shield 10a. This makes it less likely that foreign matters decrease the electromagnetic shielding capability of the electromagnetic shield 10a and allows the electromagnetic shield 10a to easily maintain a desired electromagnetic shielding capability.

The electromagnetic shield 10a can be used, for example, as an electromagnetic shield for millimeter-wave radars, millimeter-wave radio communication, millimeter-wave sensing, or the like. A device including the electromagnetic shield 10a can be used, for example, in automobiles and wireless base stations. When the electromagnetic shield 10a is for millimeter-wave radars, the electromagnetic shield 10a can be included in a millimeter-wave radar using one frequency band selected from the group consisting of the 24 GHz band, the 60 GHz band, the 76 GHz band, and the 79 GHz band. The electromagnetic shield 10a is not just for blocking only an electromagnetic wave with a particular wavelength, and may block electromagnetic waves in a wide wavelength region. It is also possible to regard an electromagnetic wave with a particular wavelength $\lambda$ as a "shielding target" of the electromagnetic shield. For example, in the case of the electromagnetic shield installed with a vehicle-mounted millimeter-wave radar configured to irradiate an object with an electromagnetic wave practically having frequencies of 76 to 77 GHz, i.e., having practical irradiation wavelengths of 3.89 to 3.94 mm, 3.92 mm which is the wavelength of the center frequency, 76.5 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 77 to 81 GHz, i.e., using an electromagnetic wave having wavelengths of 3.70 to 3.89 mm, 3.79 mm, which is the wavelength of the center frequency, 79 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 24.05 to 24.25 GHz, i.e., using an electromagnetic wave having wavelengths of 12.36 to 12.47 mm, 12.41 mm, which is the wavelength of the center frequency, 24.15 GHz, can be understood as the wavelength $\lambda$, namely, the shielding target of this electromagnetic shield. In the case where the electromagnetic shield is for millimeter-wave radars using an electromagnetic wave having frequencies of 60.0 to 60.1 GHz, i.e., using an electromagnetic wave having wavelengths of 4.99 to 5.00 mm, 4.99 mm, which is the wavelength of the center frequency, 60.05 GHz, can be understood as the wavelength $\lambda$, namely, the shielding target of this electromagnetic shield. In the case where the electromagnetic shield is for millimeter-wave radio communication using an electromagnetic wave having frequencies of 27 to 29.5 GHz, i.e., using an electromagnetic wave having wavelengths of 10.16 to 11.10 mm, 10.61 mm, which is the wavelength of the center frequency, 28.25 GHz, can be understood as the wavelength $\lambda$, namely, the shielding target of this electromagnetic shield. In the case where the electromagnetic shield is, for example, sold with a label saying that its supporting frequencies are 70 to 90 GHz, i.e., its supporting wavelengths are 3.33 to 4.28 mm, 3.75 mm, which is the wavelength of the center frequency, 80 GHz, can be understood as the wavelength $\lambda$, namely, the shielding target of this electromagnetic shield.

As shown in FIG. 1, the solid portion 15 includes, for example, a first dielectric 11a and a second dielectric 11b. The first dielectric 11a and the second dielectric 11b have different relative permittivities. In the electromagnetic shield 10a, the first dielectric 11a and the second dielectric 11b are adjacent to each other, for example, in the particular direction along the first surface 13. In the electromagnetic shield 10a, the first dielectric 11a and the second dielectric 11b are disposed, for example, alternately in the particular direction. The solid portion 15 may include three or more solid dielectrics having different relative permittivities. In this case, the different types of solid dielectrics may be disposed in a regular order or in an irregular order in the particular direction. For example, there are three types of solid dielectrics which are called "A", "B", and "C". In this example, the three types of solid dielectrics may be disposed in a regular order such as ABCABCABCA... in the particular direction or may be disposed in a less regular order such as ABCBACACBC... in the particular direction. The solid dielectrics may form the first surface 13. For example, in the electromagnetic shield 10a, the first dielectric 11a and the second dielectric 11b form the first surface 13.

As shown in FIG. 1, each of the first dielectric 11a and the second dielectric 11b extends, for example, long and thin in a direction perpendicular to the particular direction. As shown in FIG. 2, a cross-section of each of the first dielectric 11a and the second dielectric 11b is, for example, rectangular, the cross-section being perpendicular to a longitudinal direction of the dielectric.

In the electromagnetic shield 10a, for example, the first dielectrics 11a are disposed apart from each other. Additionally, the second dielectrics 11b are disposed apart from each other. At least one of the solid dielectrics may be formed as one continuous piece intersecting the particular direction at a plurality of positions.

The electromagnetic wave transmission properties of each of the solid dielectrics included in the solid portion 15 are not limited to particular properties. For example, each of the solid dielectrics included in the solid portion 15 exhibits a transmittance Td of 20% or more when an electromagnetic wave having the wavelength $\lambda$ that is a shielding target of the solid dielectric is incident perpendicularly on a 3 mm-thick flat plate made of the solid dielectric. Since each solid dielectric has such a transmittance, the electromagnetic shield 10a is likely to exhibit a desired electromagnetic shielding capability.

The transmittance Td is desirably 30% or more, more desirably 40% or more, even more desirably 50% or more, and particularly desirably 55% or more.

As shown in FIG. 2, the first surface 13 is, for example, a flat surface. This structural feature makes it less likely for foreign matters to accumulate on the electromagnetic shield 10a. Hence, the electromagnetic shield 10a more easily maintains a desired electromagnetic shielding capability.

In the electromagnetic shield 10a, the solid dielectrics adjacent to each other are, for example, in contact with each other. The solid dielectrics adjacent to each other may be adhered to each other, for example, with an adhesive.

As shown in FIG. 2, the solid portion 15 is, for example, in a plate shape. The solid portion 15 has a second surface 14 on the side opposite to the first surface 13 side in the thickness direction of the solid portion 15. The first surface 13 and the second surface 14 of the solid portion 15 are, for example, parallel to each other and flat. A rib may be disposed on the second surface 14 for reinforcement.

The wavelength $\lambda$ of an electromagnetic wave to be incident on the electromagnetic shield 10a is not limited to a particular value. The wavelength $\lambda$ is, for example, 1 mm to 30 mm.

When an electromagnetic wave with the wavelength $\lambda$ is allowed to be perpendicularly incident on the first surface 13 of the electromagnetic shield 10a, a transmission loss of the electromagnetic wave in the straight direction thereof is not limited to a particular value. It is understood that the greater the transmission loss in the straight direction, the better electromagnetic shielding capability the electromagnetic shield 10a can exhibit. The transmission loss in the straight direction is, for example, 3.0 dB or more, desirably 3.5 dB or more, and more desirably 4.0 dB or more.

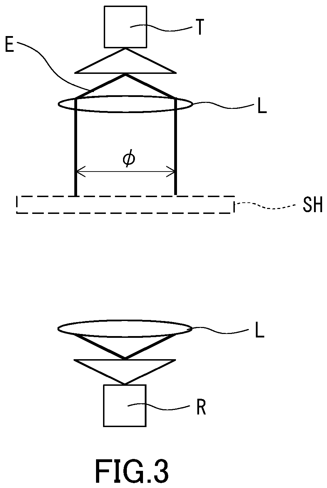

The transmission loss of the electromagnetic shield 10a in the straight direction can be determined, for example, by measurement with reference to Japanese Industrial Standards (JIS) R 1679: 2007. This measurement can be performed, for example, using a measurement system shown in FIG. 3. A sample holder SH, a millimeter-wave lens L, a transmitter T, and a receiver R are disposed as shown in FIG. 3. For example, the sample holder SH is irradiated with an electromagnetic wave E transmitted by the transmitter T, the electromagnetic wave E being adjusted to a diameter (beam diameter) of 30 mm by the millimeter-wave lens L. Transmission and reception of the electromagnetic wave E is performed without anything on the sample holder SH, and a state where the transmission loss is 0 dB (the electromagnetic wave is all transmitted) is used to determine a reference level for measurement of a transmission loss obtained by incidence in a direction perpendicular to a surface of a sample. Then, after a sample of the electromagnetic shield 10a is set on the sample holder SH, the receiver R is disposed such that the transmitter T and the receiver R are in a straight line in a direction perpendicular to a principal surface of the sample, the principal surface corresponding to the first surface 13 of the electromagnetic shield 10a. Under this condition, transmission and reception of the electromagnetic wave E with the wavelength $\lambda$ is performed, and the transmission loss in the straight direction is measured. The transmission loss is calculated by the following expression (1). In the expression (1), $P_i$ is a received electric power, and Po is a transmitted electric power. "Log" represents a common logarithm.

$$|10Log(P_i/P_0)| \quad \text{Expression (1)}$$

In the electromagnetic shield 10a, a relation between a relative permittivity $\varepsilon_1$ of the first dielectric 11a, a relative permittivity $\varepsilon_2$ of the second dielectric 11b, and a dimension d of the solid portion 15 are not limited to a particular relation. The dimension d is a dimension of the solid portion 15 in a direction perpendicular to the first surface 13. The relative permittivity $\varepsilon_1$, the relative permittivity $\varepsilon_2$, and the dimension d satisfy a requirement $0.20\lambda \le |\varepsilon_1^{0.5} - \varepsilon_2^{0.5}| \times d \le 0.80\lambda$, for example, when compared with the particular wavelength $\lambda$ being a shielding target. This structural feature is likely to increase the transmission loss in the straight direction in the electromagnetic shield 10a. Herein, the relative permittivity of a solid dielectric is, for example, a value at a frequency corresponding to the particular wavelength $\lambda$ being a shielding target thereof and is a value of a real part $\varepsilon_r'$ of a complex relative permittivity $\varepsilon_r$. The relative permittivity of a solid dielectric can be determined, for example, by the method described in EXAMPLES.

In the electromagnetic shield 10a, $|\varepsilon_1^{0.5} - \varepsilon_2^{0.5}| \times d$ may be $0.22\lambda$ or more, $0.24\lambda$ or more, $0.26\lambda$ or more, $0.28\lambda$ or more, $0.30\lambda$ or more, or $0.32\lambda$ or more. The value of $|\varepsilon_1^{0.5} - \varepsilon^{2.5}| \times d$ may be $0.78\lambda$ or less, $0.75\lambda$ or less, $0.70\lambda$ or less, $0.68\lambda$ or less, $0.65\lambda$ or less, or $0.63\lambda$ or less.

As shown in FIG. 1, the first dielectric 11a and the second dielectric 11b respectively have given dimensions W1 and W2 in the particular direction. The dimensions W1 and W2 are not limited to particular values. In the electromagnetic shield 10a, for example, the dimension W1 is $0.55\lambda$ to $2.5\lambda$ when compared with the particular wavelength $\lambda$ being a shielding target. The dimension W2 is $0.55\lambda$ to $2.5\lambda$. This structural feature is likely to increase the transmission loss in the straight direction in the electromagnetic shield 10a.

Each of the dimensions W1 and W2 may be $0.60\lambda$ or more, $0.70\lambda$ or more, $0.80\lambda$ or more, or $0.90\lambda$ or more. Each of the dimensions W1 and W2 may be $2.4\lambda$ or less, $2.3\lambda$ or less, $2.2\lambda$ or less, $2.0\lambda$ or less, $1.8\lambda$ or less, or $1.6\lambda$ or less.

As shown in FIG. 2, the first dielectric 11a and the second dielectric 11b respectively have given dimensions d1 and d2 in the direction perpendicular to the first surface 13. The dimensions d1 and d2 are not limited to particular values. In the electromagnetic shield 10a, for example, the dimension d1 is, $0.55\lambda$ to $6.5\lambda$ when compared with the particular wavelength $\lambda$ being a shielding target. For example, the dimension d2 is $0.55\lambda$ to $6.5\lambda$ when compared with the particular wavelength $\lambda$ being a shielding target. This structural feature is likely to increase the transmission loss in the straight direction in the electromagnetic shield 10a. The dimensions d1 and d2 are, for example, equal to the dimension d of the solid portion 15.

Each of the dimensions d1 and d2 may be $0.60\lambda$ or more, $0.80\lambda$ or more, $1.0\lambda$ or more, $1.2\lambda$ or more, $1.4\lambda$ or more, $1.6\lambda$ or more, $1.8\lambda$ or more, or $2.0\lambda$ or more. Each of the dimensions d1 and d2 may be $6.4\lambda$ or less, $6.2\lambda$ or less, $6.0\lambda$ or less, $5.9\lambda$ or less, $5.7\lambda$ or less, or $5.5\lambda$.

The relative permittivities of the solid dielectrics of the solid portion 15 are not limited to particular values. The solid dielectrics each have a relative permittivity of, for example, 1 to 4. In this case, the transmission loss in the straight direction is likely to increase in the electromagnetic shield 10a. The relative permittivity may be 1.2 or more, 1.5 or more, 1.7 or more, or 2.0 or more. The relative permittivity may be 3.8 or less, or 3.6 or less.

In the electromagnetic shield 10a, a difference $|\varepsilon_1 - \varepsilon_2|$ between the relative permittivity $\varepsilon_1$ of the first dielectric 11a and the relative permittivity $\varepsilon_2$ of the second dielectric 11b is not limited to a particular value. The difference $|\varepsilon_1 - \varepsilon_2|$ is, for example, 0.1 or more and 3 or less. The difference $|\varepsilon_1 - \varepsilon_2|$ may be 0.2 or more, or 0.3 or more. The difference $|\varepsilon_1 - \varepsilon_2|$ may be 2.5 or less, 2.0 or less, or 1.5 or less.

Each solid dielectric of the solid portion 15 includes, for example, a resin. In this case, the cost of manufacturing the electromagnetic shield 10a is likely to be low. The resin included in the electromagnetic shield 10a is not limited to a particular resin. The resin is, for example, a resin having a complex relative permittivity whose imaginary part ε" is 0.1 or less at at least one frequency in the range of 10 to 300 GHz. The imaginary part ε" is desirably 0.07 or less, and more desirably 0.05 or less.

The resin included in the solid dielectric is, for example, a thermoplastic resin. Examples of the resin include polyethylene, polypropylene, polyvinyl alcohol, polyethylene terephthalate, polybutylene terephthalate, ethylene-vinyl acetate copolymer, polystyrene, acrylonitrile styrene, acrylonitrile-butadiene-styrene copolymer (ABS), ASA resin, AES resin, acrylic resins such as PMMA, MS resin, MBS resin, cycloolefin resin, polyacetal resin, polyamide resin, polyester resin, polycarbonate resin, polyurethane resin, liquid crystal polymer, EPDM, PPS, PEEK, PPE, polysulfone-based resin, polyimide-based resin, fluorine-based resin, thermoplastic elastomers such as an olefin-based thermoplastic elastomer (TPO), and acrylic elastomers. The resin may be a thermosetting resin. The thermosetting resin is, for example, an epoxy resin, an acrylic resin, or a silicone resin. The solid dielectric may include two or more resins.

The solid dielectric may include, for example, a filler. The filler may be a colorant such as carbon black, an inorganic reinforcement such as talc, glass fibers, or a mineral, or a softener. The solid dielectric may include an additive such as a flame retardant or a plasticizer. The solid dielectric may be free of a filler. In this case, the cost of manufacturing the electromagnetic shield 10a is likely to be low.

The electromagnetic shield 10a is, for example, free of an electrically conductive portion. For electromagnetic shielding, it is conceivable that, for example, an electrically conductive portion such as a metal film is used to reflect an electromagnetic wave. However, the electromagnetic shield 10a can block an electromagnetic wave without an electrically conductive portion. The electromagnetic shield 10a may consist of the dielectrics. The electromagnetic shield 10a may include an electrically conductive portion.

The electromagnetic shield 10a is, for example, a resin molded article. In this case, the method for molding the electromagnetic shield 10a is not limited to a particular method. The electromagnetic shield 10a can be manufactured by injection molding, press molding, blow molding, or vacuum molding. The electromagnetic shield 10a can be manufactured, for example, by insert molding or double molding. The electromagnetic shield 10a may be manufactured by cutting or 3D printing.

For the electromagnetic shield 10a, an interaction occurring between the electromagnetic shield 10a and an electromagnetic wave for blocking of the electromagnetic wave is not limited to a particular interaction. The electromagnetic shield 10a, for example, transmits at least a portion of an electromagnetic wave incident on the first surface 13 and allows a scattered electromagnetic wave to emerge from the second surface 14. In other words, the electromagnetic shield 10a can function as a radio-wave transmitting-scattering body. Electromagnetic shielding can therefore be achieved with a simple configuration.

The electromagnetic shield 10a can function, for example, as a diffraction grating. Regarding light diffraction, a zero-order light transmittance $I_0$ through a diffraction grating in which two types of solids having different refractive indices and having rectangular cross-sections are disposed alternately is expressed by the following equation (2). The equation (2) is based on a scalar diffraction theory. In the equation (2), $\Delta n$ is a difference between the refractive indices of the two types of solids. The symbol h is a dimension of the diffraction grating in a direction perpendicular to a surface of the diffraction grating. The symbol $\lambda$ is the wavelength of light.

$$I_0 = \cos^2(\pi \cdot \Delta n \cdot (h/\lambda)) \qquad \text{Equation (2)}$$

The above discussion is made according to the light diffraction theory.

However, it is difficult to apply the discussion to radio waves such as millimeter waves. The reason is that it is necessary to take into account the fact that radio waves, particularly millimeter waves and quasi-millimeter waves, have a wavelength which is three or more orders of magnitude greater than that of visible light. For example, millimeter waves are characterized, for example, by poor straightness (a high likelihood of diffraction) compared to visible light and a high likelihood of transmission through objects such as plastic walls and paper compared to visible light, and these characteristics need to be taken into account in designing.

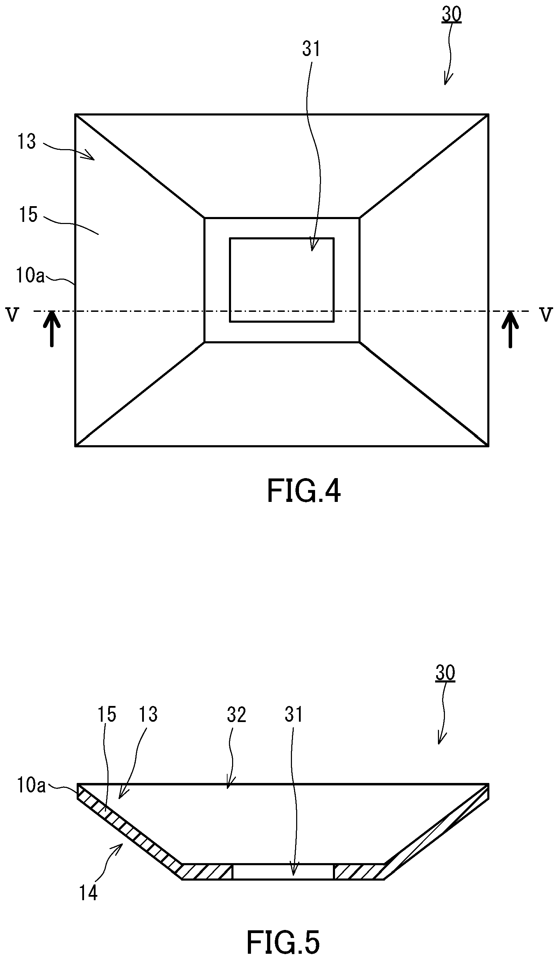

As shown in FIGS. 4 and 5, at least one selected from the group consisting of the electromagnetic shield 10a and the solid portion 15 is, for example, a ring-shaped body and has a polygonal or circular outer perimeter when the first surface 13 is viewed along an axis of the ring-shaped body. This structural feature makes it possible to block an electromagnetic wave incident on the first surface 13 through a space surrounded by the electromagnetic shield 10a.

As shown in FIG. 4 and 5, an outer shape of at least one selected from the group consisting of the electromagnetic shield 10a and the solid portion 15 is, for example, a truncated pyramidal shape. At least one selected from the group consisting of the electromagnetic shield 10a and the solid portion 15 is, for example, a hollow body and has an opening in each of positions in the outer shape, the positions corresponding to an upper base and a lower base of a truncated pyramid. At least one selected from the group consisting of the electromagnetic shield 10a and the solid portion 15 has, for example, a first opening 31 in a position corresponding to the upper base of a truncated pyramid and a second opening 32 in a position corresponding to the lower base thereof. The first surface 13 is an inner side surface of the hollow body being the electromagnetic shield 10a or the solid portion 15. The second surface 14 is an outer side surface of the hollow body being the electromagnetic shield 10a or the solid portion 15. Such a structural feature makes it likely that electromagnetic shielding by the electromagnetic shield 10a is achieved in a larger space. Furthermore, the first opening 31 of the electromagnetic shield 10a can be used to dispose therein an antenna for transmission and reception of an electromagnetic wave. The outer shape of at least one selected from the group consisting of the electromagnetic shield 10a and the solid portion 15 may be a truncated conical shape or a truncated elliptical conical shape. In this case, the electromagnetic shield 10a has an opening in each of positions in the outer shape, the positions corresponding to the upper base and the lower base of a truncated cone or a truncated elliptic cone.

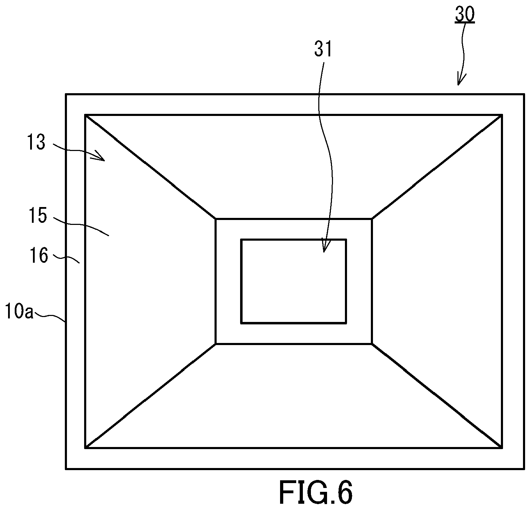

The electromagnetic shield 10a may be modified, for example, as shown in FIG. 6. As shown in FIG. 6, the electromagnetic shield 10a further includes, for example, a contact portion 16. The contact portion 16 is a portion configured to be in contact with a component other than the electromagnetic shield 10a. The contact portion 16 abuts on a polygonal or circular outer perimeter observed when the first surface 13 is viewed along the axis of the electromagnetic shield 10a or the solid portion 15 in a ring shape. With such a structural feature, the electromagnetic shield 10a can be attached to another component with the contact portion 16 in contact with the component. The contact portion 16 forms, for example, a flange.

As shown in FIGS. 4 and 5, for example, a radar cover 30 including the electromagnetic shield 10a can be provided. The radar cover 30 can block an unnecessary radio wave traveling toward a radar using the electromagnetic shield 10a. This makes it less likely that the radar receives unnecessary radio waves.

As shown in FIGS. 4 and 5, the radar cover 30 is, for example, in the shape of a hollow truncated pyramid, and has the first opening 31 and the second opening 32. Each of the first opening 31 and the second opening 32 is rectangular. The second opening 32 is bigger than the first opening 31. For example, a transceiving antenna of a radar (not illustrated) is disposed in the first opening 31. A portion of an internal surface of the radar cover 30 is the first surface 13 of the solid portion 15 of the electromagnetic shield 10a, and a portion of an outer surface of the radar cover 30 is the second surface 14 of the solid portion 15.

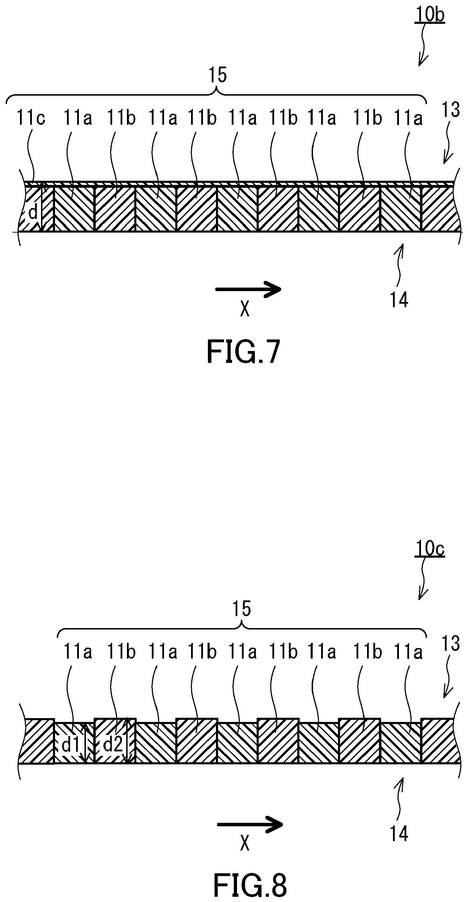

The electromagnetic shield 10a can be modified in various respects. The electromagnetic shield 10a may be modified to an electromagnetic shield 10b shown in FIG. 7, an electromagnetic shield 10c shown in FIG. 8, or an electromagnetic shield 10d shown in FIGS. 9 and 10. Each of the electromagnetic shield 10b, the electromagnetic shield 10c, and the electromagnetic shield 10d is configured in the same manner as the electromagnetic shield 10a unless otherwise described. The components of the electromagnetic shield 10b, the electromagnetic shield 10c, and the electromagnetic shield 10d that are the same as or correspond to the components of the electromagnetic shield 10a are denoted by the same reference characters, and detailed descriptions of such components are omitted. The description given for the electromagnetic shield 10a applies to the electromagnetic shield 10b, the electromagnetic shield 10c, and the electromagnetic shield 10d, unless there is technical inconsistency.

As shown in FIG. 7, in the electromagnetic shield 10b, the solid portion 15 has a skin layer 11c. The skin layer 11c forms an outermost layer of the solid portion 15 and is made of one of the solid dielectrics. With such structural features, the skin layer 11c can protect the solid portion 15, thereby reducing deformation of the electromagnetic shield 10b and damage thereto. This makes it likely that the electromagnetic shield 10b exhibits a desired electromagnetic shielding capability for a long period of time. As the skin layer 11c is made of one of the solid dielectrics, no special material needs to be prepared for formation of the skin layer 11c. This can simplify the method for manufacturing the electromagnetic shield 10b. In the electromagnetic shield 10b, the skin layer 11c forms, for example, the first surface 13. The skin layer 11c may form the second surface 14.

A thickness of the skin layer 11c is not limited to a particular value. The thickness is, for example, 300 $\mu$m to 3000 $\mu$m. The thickness may be 400 $\mu$m or more, or 500 $\mu$m or more. The thickness may be 2000 $\mu$m or less, or 1000 $\mu$m or less.

As shown in FIG. 8, in the electromagnetic shield 10c, the first surface 13 has a step. In the electromagnetic shield 10c, for example, the dimensions d1 and d2 are different. Even in this case, it is likely that the height of the first surface 13 varies less greatly than in an electromagnetic shield formed using one type of solid dielectric having a given relative permittivity. Therefore, foreign matters are less likely to accumulate on the electromagnetic shield 10c. In the electromagnetic shield 10c, for example, d2 > d1 is satisfied. A ratio d1/d2 of the dimension d1 to the dimension d2 is, for example, 0.5 or more. In this case, the first surface 13 can be regarded as flat. The ratio d1/d2 may be 0.6 or more, 0.7 or more, 0.8 or more, or 0.9 or more. In the electromagnetic shield 10c, for example, {(d1 $\times$ S1) + (d2 $\times$ S2)}/St can be employed as the value of the dimension d of the solid portion 15. The symbol S1 is the total area of the first dielectrics 11a measured when the first surface 13 of the electromagnetic shield 10c is viewed in plan. The symbol S2 is the total area of the second dielectrics 11b measured when the first surface 13 of the electromagnetic shield 10c is viewed in plan. The symbol St is the area of the first surface 13 measured when the first surface 13 of the electromagnetic shield 10c is viewed in plan. In the electromagnetic shield 10c, St = S1 + S2 is satisfied.

For example, in the case of manufacturing the electromagnetic shield 10c by injection molding, adjustment of the arrangement of the first dielectric 11a and the second dielectric 11b in the electromagnetic shield 10c makes it possible to release a molded product from a cavity or a core.

As shown in FIG. 9, in the electromagnetic shield 10d, the solid dielectrics are disposed in turn in contact with each other in a plurality of particular directions (an X1 axis direction and an X2 axis direction) along the first surface 13. This structural feature makes it easy for the electromagnetic shield 10d to exhibit a desired electromagnetic shielding capability against radio waves coming from various directions.

Each solid dielectric is, for example, square in plan view. The solid dielectrics are disposed, for example, to make a square lattice in plan view.

The shape of each solid dielectric in plan view is not limited to a particular shape. The shape may be a rectangle, a triangle, a hexagon, a polygon other than these, a circle, an ellipse, or an irregular shape. The solid dielectrics may be disposed to make a parallelogram lattice or a rectangular lattice in plan view. Each solid dielectric may be formed apart from the other solid dielectrics at a plurality of positions along the first surface 13, or each solid dielectric may be formed as one continuous piece intersecting the particular direction along the first surface 13 at a plurality of positions.

EXAMPLES

The present invention will be described hereinafter in more details by examples. The present invention is not limited to the examples given below. First, evaluation methods for Examples and Comparative Examples will be described.

[Transmission loss]

A radio wave having a frequency of 77 GHz and a diameter of 30 mm was allowed to be incident on one principal surface of each of samples according to Examples and Comparative Examples, and a transmission loss in a straight direction of the radio wave was measured using a radio transceiver EAS02 manufactured by KEYCOM Corporation with reference to JIS R 1679: 2007. The wavelength $\lambda$ of this radio wave was 3.9 mm. This measurement was performed in the same manner as in the measurement in which a measurement system shown in FIG. 3 is used. A distance between an antenna and a measurement specimen was determined with reference to 8.2.2 Measurement Distance and Accompanying Document H in JIS R 1679: 2007. In this measurement, in the case of a sample obtained by arranging pieces of a plurality of types of resins, the radio wave was generated such that an amplitude direction of an electric field of the radio wave coincided with an arrangement direction of the pieces of the plurality of types of resins in each sample. In this measurement, the smallest absolute value of transmission loss was determined by moving each of the samples according to Examples in the arrangement direction of the pieces of the plurality of types of resins. The transmission loss was determined by the above expression (1). Table 1 shows the results.

[Relative permittivity and transmittance]

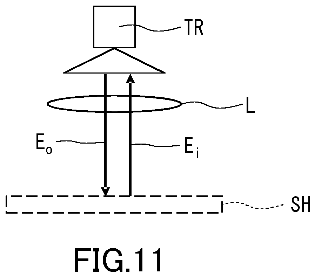

Return losses of flat resin plates according to Comparative Examples 1-1, 1-2, 2-1, 2-2, 3-1, and 3-2 at 70 to 90 GHz were measured by the following procedure with reference to JIS R 1679:2007 using a radio transceiver EAS02 manufactured by KEYCOM Corporation. A sample holder SH and a transceiver TR were disposed as shown in FIG. 11, and transmission and reception of radio waves was performed with a metal plate made of stainless steel disposed on the sample holder SH. The metal plate had a diameter of 150 mm and a thickness of 2 mm. A state where a radio wave was all reflected by the metal plate and the return loss was 0 dB was used to determine a level that serves as a reference level for measurement of a return loss obtained by perpendicular incidence of a radio wave on each flat resin plate. Then, each flat resin plate was disposed on the sample holder SH in place of the metal plate, transmission and reception of radio waves was performed, and return losses were measured.

Next, transmission losses of a flat plate of each resin at 70 to 90 GHz were measured in the same manner as the above transmission loss measurement method.

An impedance Z and a propagation constant $\gamma$ of the material are represented by the following equations (3) and (4). In the equations (3) and (4), $Z_0$ is the impedance of air. The symbol $\mu_r$ is a relative magnetic permeability of the material, and a relation $\mu_r = \mu_r' - j\mu_r''$ is established. The symbol $\varepsilon_r$ is a relative permittivity of the material, and a relation $\varepsilon_r = \varepsilon_r' - j\varepsilon_r''$ is established. The symbol $\lambda$ is the wavelength of a radio wave. The symbol j is the imaginary unit.

$$Z = Z_0(\mu_r/\varepsilon_r)^{0.5} \quad \text{Equation (3)}$$

$$\gamma = (j2\pi/\lambda)\varepsilon_r^{0.5}\mu_r^{0.5} \quad \text{Equation (4)}$$

Assuming that the object has a thickness of t, the return loss and the transmission loss are expressed using the above impedance Z and the above propagation constant $\gamma$ by the following equations (5) and (6) according to the transmission line theory. In the equations (5) and (6), relations A = cosh($\gamma$t), B = Zsinh($\gamma$t), C = (1/Z)sinh($\gamma$t), and D = cosh($\gamma$t) are established.

$$\text{Transmission loss (dB)} = 20\log\{2/(A + B/Z_0 + CZ_0 + D)\} \quad \text{Equation (5)}$$

$$\text{Return loss (dB)} = 20\log\{(A + B/Z_0 - CZ_0 - D)/(A + B/Z_0 + CZ_0 + D) \quad \text{Equation (6)}$$

Predicted values of the relative magnetic permeability $\mu_r$ and the relative permittivity $\varepsilon_r$ were substituted into the equations (5) and (6). On the basis of the resulting values Z and $\gamma$ and the thickness t of the flat plate of the resin, return losses and transmission losses at 70 to 90 GHz were calculated by the equations (5) and (6).

Curve fitting by the least-squares method was performed using a curve of the return losses calculated by the actual values and a curve of the return losses calculated by the above equations (3), (4), and (5). In addition, curve fitting by the least-squares method was performed using a curve of the transmission losses calculated by the actual values and a curve of the transmission losses calculated by the above equations (3), (4), and (6). Possible relative permittivities $\varepsilon_r$ of each resin were determined thereby. Table 2 shows the results.

On the basis of the impedance Z and the propagation constant $\gamma$ obtained by substituting the obtained relative permittivity $\varepsilon_r$ of each resin in the equations (3) and (4), a transmittance [%] of a radio wave perpendicularly incident on a flat plate of the resin having a thickness t of 3 mm was calculated by the following equation (7). Table 2 shows the results.

$$\text{Transmittance [\%]} = 100 \times |2/(A + B/Z_0 + CZ_0 + D)|^2 \quad \text{Equation (7)}$$

[Property value P]

A property value P was determined for each of the samples according to Examples by the following equation (8). In the equation (8), $\varepsilon_m$ is the real part of the relative permittivity of one of a pair of resins adjacent to each other, and $\varepsilon_n$ is the real part of the relative permittivity of the other. The symbol d is the thickness of the sample. The symbol $\lambda$ is the wavelength of a radio wave with a frequency of 77 GHz. Table 1 shows the results.

$$\text{Property value P} = |\varepsilon_m^{0.5} - \varepsilon_n^{0.5}| \times d/\lambda \quad \text{Equation (8)}$$

<Example1-1>

A flat polypropylene (PP) plate was cut to produce long and thin prismatic PP pieces. A cross-section of each PP piece was rectangular and measured 17 mm in length and 4 mm in width, the cross-section being perpendicular to the longitudinal direction of the PP piece. The real part and the imaginary part of the complex relative permittivity of the PP were respectively 2.30 and 0.00. A flat acrylonitrile-butadiene-styrene copolymer (ABS) plate was cut to produce long and thin prismatic ABS pieces. A cross-section of each ABS piece was rectangular and measured 17 mm in length and 4 mm in width, the cross-section being perpendicular to the longitudinal direction of the ABS piece. The real part and the imaginary part of the complex relative permittivity of the ABS were respectively 2.65 and 0.02. The PP pieces and the ABS pieces were alternately arranged without a gap therebetween, and the pieces were fixed with adhesive tape at their longitudinal ends on both sides. A flat-plate-shaped sample according to Example 1 was produced in this manner. The sample according to Example 1 had a thickness of 17 mm, and each piece had a width of 4 mm in the arrangement direction of the pieces.

<Examples 1-2 to 1-11>

Samples according to Example 1-2 to Example 1-11 were produced in the same manner as in Example 1-1, except that the thickness of each sample and the width of each piece in the arrangement direction of the pieces were changed as shown in Table 1.

<Example 2>

A flat ABS plate was cut to produce long and thin prismatic ABS pieces. A cross-section of each ABS piece was rectangular and measured 8 mm in length and 4 mm in width, the cross-section being perpendicular to the longitudinal direction of the ABS piece. A flat nylon6 (PA6) plate was cut to produce long and thin prismatic PA6 pieces. A cross-section of each PA6 piece was rectangular and measured 8 mm in length and 4 mm in width, the cross-section being perpendicular to the longitudinal direction of the PA6 piece. The real part and the imaginary part of the complex relative permittivity of the PA6 were respectively 3.49 and 0.05. The ABS pieces and the PA6 pieces were alternately arranged without a gap therebetween, and the pieces were fixed with adhesive tape at their longitudinal ends on both sides. A flat-plate-shaped sample according to Example 2 was produced in this manner. The sample according to Example 2 had a thickness of 8 mm, and each piece had a width of 4 mm in the arrangement direction of the pieces.

<Example 3>

A flat PP plate was cut to produce long and thin prismatic PP pieces. A cross-section of each PP piece was rectangular and measured 6 mm in length and 4 mm in width, the cross-section being perpendicular to the longitudinal direction of the PP piece. The real part and the imaginary part of the complex relative permittivity of the PP were respectively 2.30 and 0.00. A flat PA6 plate was cut to produce long and thin prismatic PA6 pieces. A cross-section of each PA6 piece was rectangular and measured 6 mm in length and 4 mm in width, the cross-section being perpendicular to the longitudinal direction of the PA6 piece. The real part and the imaginary part of the complex relative permittivity of the PA6 were respectively 3.49 and 0.05. The PP pieces and the PA6 pieces were alternately arranged without a gap therebetween, and the pieces were fixed with adhesive tape at their longitudinal ends on both sides. A flat-plate-shaped sample according to Example 3 was produced in this manner. The sample according to Example 3 had a thickness of 6 mm, and each piece had a width of 4 mm in the arrangement direction of the pieces.

<Example 4>

A flat PP plate was cut to produce long and thin prismatic PP pieces. A cross-section of each PP piece was rectangular and measured 8 mm in length and 4 mm in width, the cross-section being perpendicular to the longitudinal direction of the PP piece. The real part and the imaginary part of the complex relative permittivity of the PP were respectively 2.30 and 0.00. A flat ABS plate was cut to produce long and thin prismatic ABS pieces. A cross-section of each ABS piece was rectangular and measured 8 mm in length and 4 mm in width, the cross-section being perpendicular to the longitudinal direction of the ABS piece. A flat PA6 plate was cut to produce long and thin prismatic PA6 pieces. A cross-section of each PA6 piece was rectangular and measured 8 mm in length and 4 mm in width, the cross-section being perpendicular to the longitudinal direction of the PA6 piece. The real part and the imaginary part of the complex relative permittivity of the PA6 were respectively 3.49 and 0.05. The PP pieces, the ABS pieces, and the PA6 pieces were arranged in turn in the order of the PP piece, the ABS piece, and the PA6 piece without a gap therebetween, and the pieces were fixed with adhesive tape at their longitudinal ends on both sides. A flat-plate-shaped sample according to Example 4 was produced in this manner. The sample according to Example 4 had a thickness of 8 mm, and each piece had a width of 4 mm in the arrangement direction of the pieces.

<Comparative Example 1-1 >

A 17 mm-thick flat PP plate was prepared as a sample according to Comparative Example 1-1.

<Comparative Example 1-2>

A 6 mm-thick flat PP plate was prepared as a sample according to Comparative Example 1-2.

<Comparative Example 2-1>

A 17 mm-thick flat ABS plate was prepared as a sample according to Comparative Example 2-1.

<Comparative Example 2-2>

An 8 mm-thick flat ABS plate was prepared as a sample according to Comparative Example 2-2.

<Comparative Example 3-1>

An 8 mm-thick flat PA6 plate was prepared as a sample according to Comparative Example 3-1.

<Comparative Example 3-2>

A 6 mm-thick flat PA6 plate was prepared as a sample according to Comparative Example 3-2.

<Comparative Example 4-1>

A flat PP plate was cut to produce long and thin prismatic PP pieces. A cross-section of each PP piece was rectangular and measured 17 mm in length and 4 mm in width, the cross-section being perpendicular to the longitudinal direction of the PP piece. The real part and the imaginary part of the complex relative permittivity of the PP were respectively 2.30 and 0.00. The PP pieces were arranged in parallel to each other with a 4 mm-wide gap therebetween, and the pieces were fixed with adhesive tape at their longitudinal ends on both sides. A sample according to Comparative Example 4-1 in which the PP and a gap were alternately disposed was produced in this manner. The sample according to Comparative Example 4-1 had a thickness of 17 mm, and each piece had a width of 4 mm in the arrangement direction of the pieces.

<Comparative Example 4-2>

A sample according to Comparative Example 4-2 was produced in the same manner as in Comparative Example 4-1, except that the dimension of the PP piece were changed so that the sample would have a thickness of 6 mm.

<Comparative Example 5-1>

A flat ABS plate was cut to produce long and thin prismatic ABS pieces. A cross-section of each ABS piece was rectangular and measured 17 mm in length and 4 mm in width, the cross-section being perpendicular to the longitudinal direction of the ABS piece. The real part and the imaginary part of the complex relative permittivity of the ABS were respectively 2.65 and 0.02. The ABS pieces were arranged in parallel to each other with a 4 mm-wide gap therebetween, and the pieces were fixed with adhesive tape at their longitudinal ends on both sides. A sample according to Comparative Example 5-1 in which the ABS and a gap were alternately disposed was produced in this manner. The sample according to Comparative Example 5-1 had a thickness of 17 mm, and each piece had a width of 4 mm in the arrangement direction of the pieces.

<Comparative Example 5-2>

A sample according to Comparative Example 5-2 was produced in the same manner as in Comparative Example 5-1, except that the dimension of the ABS piece was changed so that the sample would have a thickness of 8 mm.

<Comparative Example 6>

A flat PA6 plate was cut to produce long and thin prismatic PA6 pieces. A cross-section of each PA6 piece was rectangular and measured 6 mm in length and 4 mm in width, the cross-section being perpendicular to the longitudinal direction of the PA6 piece. The real part and the imaginary part of the complex relative permittivity of the PA6 were respectively 2.65 and 0.02. The PA6 pieces were arranged in parallel to each other with a 4 mm-wide gap therebetween, and the pieces were fixed with adhesive tape at their longitudinal ends on both sides. A sample according to Comparative Example 6 in which the PA6 and a gap were alternately disposed was produced in this manner. The sample according to Comparative Example 6 had a thickness of 6 mm, and each piece had a width of 4 mm in the arrangement direction of the pieces.

As shown in Table 1, the transmission losses of the samples according to Examples are larger than the transmission losses of the samples according to Comparative Example 1-1 to Comparative Example 3-2. Although the samples according to Comparative Example 4-1 to Comparative Example 6 have large transmission losses, it is inferred that foreign matters are likely to accumulate on these samples for the gaps between the resin pieces thereof. On the other hand, the samples according to Examples have no such gaps, and thus foreign matters are thought to be less likely to accumulate thereon.

[Table 1]

| | Material | Thickness d [mm] | Width W of each piece [mm] | $d/\lambda$ | $W/\lambda$ | Property value P | Transmission loss in straight direction [dB] |
|---|---|---|---|---|---|---|---|
| Example 1-1 | PP/ABS | 17 | 4 | 4.4 | 1.0 | 0.49 | 6.7 |
| Example 1-2 | PP/ABS | 10 | 4 | 2.6 | 1.0 | 0.29 | 4.1 |
| Example 1-3 | PP/ABS | 12 | 4 | 3.1 | 1.0 | 0.34 | 5.7 |
| Example 1-4 | PP/ABS | 14 | 4 | 3.6 | 1.0 | 0.40 | 5.8 |
| Example 1-5 | PP/ABS | 16 | 4 | 4.1 | 1.0 | 0.46 | 6.9 |
| Example 1-6 | PP/ABS | 19 | 4 | 4.9 | 1.0 | 0.54 | 6.6 |
| Example 1-7 | PP/ABS | 21 | 4 | 5.4 | 1.0 | 0.60 | 6.6 |
| Example 1-8 | PP/ABS | 23 | 4 | 5.9 | 1.0 | 0.66 | 4.6 |
| Example 1-9 | PP/ABS | 25 | 4 | 6.4 | 1.0 | 0.71 | 4.2 |
| Example 1-10 | PP/ABS | 17 | 6 | 4.4 | 1.5 | 0.49 | 6.9 |
| Example 1-11 | PP/ABS | 17 | 8 | 4.4 | 2.1 | 0.49 | 4.4 |
| Example 2 | ABS/PA6 | 8 | 4 | 2.1 | 1.0 | 0.49 | 4.2 |
| Example 3 | PP/PA6 | 6 | 4 | 1.5 | 1.0 | 0.54 | 10.7 |
| Example 4 | PP/ABS/PA6 | 8 | 4 | 2.1 | 1.0 | 0.23 0.49 0.72 | 5.4 |
| Comparative Example 1-1 | PP | 17 | - | - | - | - | 1.2 |
| Comparative Example 1-2 | PP | 6 | - | - | - | - | 0.4 |
| Comparative Example 2-1 | ABS | 17 | - | - | - | - | 2.2 |
| Comparative Example 2-2 | ABS | 8 | - | - | - | - | 1.1 |
| Comparative Example 3-1 | PA6 | 8 | - | - | - | - | 2.1 |
| Comparative Example 3-2 | PA6 | 6 | - | - | - | - | 2.0 |
| Comparative Example 4-1 | PP/Air | 17 | 4 | 4.4 | 1.0 | - | 5.2 |
| Comparative Example 4-2 | PP/Air | 6 | 4 | 1.5 | 1.0 | - | 4.2 |
| Comparative Example 5-1 | ABS/Air | 17 | 4 | 4.4 | 1.0 | - | 4.8 |
| Comparative Example 5-2 | ABS/Air | 8 | 4 | 2.1 | 1.0 | - | 8.0 |
| Comparative Example 6 | ABS/Air | 6 | 4 | 1.5 | 1.0 | - | 8.5 |

[Table 2]

| Resin | Complex relative permittivity | | Radio wave transmittance through 3 mm-thick flat plate [%] |
|---|---|---|---|
| | Real part | Imaginary part | |
| PP | 2.30 | 0.00 | 90 |
| ABS | 2.65 | 0.02 | 76 |
| PA6 | 3.49 | 0.05 | 81 |

**Claims**

1. An electromagnetic shield comprising

   a plate-shaped solid portion having a first surface configured to allow an electromagnetic wave to be incident on the first surface, wherein
   the solid portion includes solid dielectrics having different relative permittivities, and
   the solid dielectrics are disposed in turn in contact with each other in a particular direction along the first surface.

2. The electromagnetic shield according to claim 1, wherein the electromagnetic shield is free of an electrically conductive portion.

3. The electromagnetic shield according to claim 1, wherein

   the electromagnetic shield is capable of shielding against an electromagnetic wave with a wavelength $\lambda$, and
   each of the solid dielectrics exhibits a transmittance of 20% or more when the electromagnetic wave is incident perpendicularly on a 3 mm-thick flat plate made of the solid dielectric.

4. The electromagnetic shield according to claim 1, wherein the first surface is a flat surface.

5. The electromagnetic shield according to any one of claims 1 to 4, wherein

   the electromagnetic shield is capable of shielding against an electromagnetic wave with a wavelength $\lambda$,
   the solid dielectrics include a first dielectric and a second dielectric adjacent to each other in the particular direction along the first surface, the first dielectric and the second dielectric having different relative permittivities, and
   a relative permittivity $\varepsilon_1$ of the first dielectric, a relative permittivity $\varepsilon_2$ of the second dielectric, and a dimension d of the solid portion in a direction perpendicular to the first surface satisfy a requirement $0.20\lambda \leq |\varepsilon_1^{0.5} - \varepsilon_2^{0.5}| \times d \leq 0.80\lambda$.

6. The electromagnetic shield according to any one of claims 1 to 5, wherein

   the electromagnetic shield is capable of shielding against an electromagnetic wave with a wavelength $\lambda$,
   the solid dielectrics include a first dielectric and a second dielectric adjacent to each other in the particular direction along the first surface, the first dielectric and the second dielectric having different relative permittivities,
   a dimension of the first dielectric in the particular direction is $0.55\lambda$ to $2.5\lambda$, and
   a dimension of the second dielectric in the particular direction is $0.55\lambda$ to $2.5\lambda$.

7. The electromagnetic shield according to any one of claims 1 to 6, wherein

   the electromagnetic shield is capable of shielding against an electromagnetic wave with a wavelength $\lambda$,
   the solid dielectrics include a first dielectric and a second dielectric adjacent to each other in the particular direction along the first surface, the first dielectric and the second dielectric having different relative permittivities,
   a dimension of the first dielectric in a direction perpendicular to the first surface is $0.55\lambda$ to $6.5\lambda$, and
   a dimension of the second dielectric in the direction perpendicular to the first surface is $0.55\lambda$ to $6.5\lambda$.

8. The electromagnetic shield according to any one of claims 1 to 7, wherein the solid dielectrics each have a relative permittivity of 1 to 4.

9. The electromagnetic shield according to any one of claims 1 to 8, wherein the solid portion has a skin layer forming an outermost layer of the solid portion and made of one of the solid dielectrics.

10. The electromagnetic shield according to any one of claims 1 to 9, wherein

at least one selected from the group consisting of the electromagnetic shield and the solid portion is a ring-shaped body and has a polygonal or circular outer perimeter when the first surface is viewed along an axis of the ring-shaped body,
the electromagnetic shield further includes a contact portion configured to be in contact with a component other than the electromagnetic shield, and
the contact portion abuts on the outer perimeter.

11. The electromagnetic shield according to any one of claims 1 to 10, wherein

at least one selected from the group consisting of the electromagnetic shield and the solid portion is a hollow body whose outer shape is a truncated pyramidal shape, a truncated conical shape, or a truncated elliptical conical shape and which has an opening in each of positions in the outer shape, the positions corresponding to an upper base and a lower base of a truncated pyramid, a truncated cone, or a truncated elliptic cone, and
the first surface is an inner side surface of the hollow body being the electromagnetic shield or the solid portion.

FIG.1

FIG.2

FIG.3

FIG.4

FIG.5

FIG.6

10b

15

11c 11a 11b 11a 11b 11a 11b 11a 11b 11a    13

d

X

14

# FIG.7

10c

15

11a 11b 11a 11b 11a 11b 11a 11b 11a    13

d1 d2

X

14

# FIG.8

FIG.9

FIG.10

FIG.11

## INTERNATIONAL SEARCH REPORT

| International application No. |
| --- |
| **PCT/JP2022/032686** |

**A. CLASSIFICATION OF SUBJECT MATTER**

*G01S 7/03*(2006.01)i; *H01Q 1/52*(2006.01)i; *H01Q 17/00*(2006.01)i; *H05K 9/00*(2006.01)i
FI: G01S7/03 246; H01Q1/52; H01Q17/00; H05K9/00 W

According to International Patent Classification (IPC) or to both national classification and IPC

**B. FIELDS SEARCHED**

Minimum documentation searched (classification system followed by classification symbols)

G01S7/00-7/51; G01S13/00-13/95; H01Q1/00-1/52; H01Q15/00-19/32; H05K9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2004-153135 A (NICHIAS CORP) 27 May 2004 (2004-05-27) paragraphs [0001]-[0034], fig. 1-7 | 1-9 |
| Y | paragraphs [0001]-[0034], fig. 1-7 | 10-11 |
| Y | WO 2021/010483 A1 (KOITO MANUFACTURING CO., LTD.) 21 January 2021 (2021-01-21) paragraphs [0070]-[0074], fig. 10-11 | 10-11 |
| X | JP 2008-135485 A (TAIKA KK) 12 June 2008 (2008-06-12) paragraphs [0031]-[0034], fig. 1 | 1, 4 |
| Y | paragraphs [0031]-[0034], fig. 1 | 10-11 |
| X | JP 2011-14723 A (YUPO CORP) 20 January 2011 (2011-01-20) paragraphs [0015]-[0022] | 1-2, 4 |
| A | JP 2007-324317 A (TOSHIBA CORP) 13 December 2007 (2007-12-13) entire text, all drawings | 1-11 |

☑ Further documents are listed in the continuation of Box C.   ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **26 October 2022** | **08 November 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

| International application No. |
| --- |
| **PCT/JP2022/032686** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2016/0324041 A1 (INDUSTRY-ACADEMIC COOP. FOUND. YONSEI UNIV.) 03 November 2016 (2016-11-03) <br> entire text, all drawings | 1-11 |

Form PCT/ISA/210 (second sheet) (January 2015)

**INTERNATIONAL SEARCH REPORT**
Information on patent family members

International application No.

**PCT/JP2022/032686**

| Patent document cited in search report | | | Publication date (day/month/year) | Patent family member(s) | | | Publication date (day/month/year) |
|---|---|---|---|---|---|---|---|
| JP | 2004-153135 | A | 27 May 2004 | (Family: none) | | | |
| WO | 2021/010483 | A1 | 21 January 2021 | US 2022/316678 A1 paragraphs [0134]-[0138], fig. 10-11 EP 4001016 A1 CN 112240538 A | | | |
| JP | 2008-135485 | A | 12 June 2008 | (Family: none) | | | |
| JP | 2011-14723 | A | 20 January 2011 | (Family: none) | | | |
| JP | 2007-324317 | A | 13 December 2007 | (Family: none) | | | |
| US | 2016/0324041 | A1 | 03 November 2016 | KR 10-2016-0126113 A | | | |

Form PCT/ISA/210 (patent family annex) (January 2015)

**EP 4 397 990 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021058450 A1

- JP 2004153135 A